# EUROPEAN PATENT SPECIFICATION

(11) **EP 3 550 246 B1**
(45) Date of publication and mention of the grant of the patent: **09.12.2020**
(21) Application number: 19166756.7
(22) Date of filing: 02.04.2019
(51) Int. Cl.: F28D 1/03, F28D 1/047, H05K 7/20, H01L 23/473

(54) **WRAP AROUND HEAT EXCHANGER**
RUNDUMWÄRMETAUSCHER
ÉCHANGEUR DE CHALEUR ENVELOPPANT

(30) Priority: 03.04.2018 US 201815943931
(43) Date of publication of application: 09.10.2019
(73) Proprietor: Aavid Thermalloy, LLC, Laconia, NH 03246 (US)
(72) Inventor: Cook, Randolph H., Gilford, NH New Hampshire 03249 (US); Turmelle, Chad, Pembroke, NH New Hampshire 03275 (US); Sce, Andrea, 40037 Sasso Marconi (BO) (IT); Fernández Osorio, Marina, 40016 San Giorgio Di Piano (BO) (IT)
(74) Representative: Hoffmann Eitle

(56) References cited:
- JP-A- 2009 141 183
- US-A1- 2005 040 515
- US-A1- 2012 097 381
- US-A1- 2014 262 177
- US-A1- 2015 200 429
- US-A1- 2016 234 975
- US-B1- 6 349 035

## Description

### BACKGROUND

Heat transfer with respect to components such as computer processors and other electronic components, heat sinks, etc., is frequently required for a variety of different applications. In many cases, heat can be provided to, or received from, components using a heat transfer fluid, such as a circulated liquid or gas.

For example, US 2016/0234975 A1 relates to a heat exchanger for cooling an electric element and a heat exchanger assembly for cooling an electric element capable of facilitating an insertion of the electric element and improving cooling performance by contacting both side surfaces of the electric element and a tube in which cooling water flows to each other. Further, US 2015/0200429 A1 relates to a battery module including a flexible heat dissipating unit and US 2005/0040515 A1 to a coolant cooled type semiconductor device.

### SUMMARY OF INVENTION

The present invention is defined in the independent claims, wherein the claims dependent thereon specify preferred embodiments.

In some embodiments, aspects of the invention provide for an assembly for transferring heat with respect to a component where the assembly includes a first heat transfer plate having a first surface arranged to contact and transfer heat with respect to a first component surface, and a second heat transfer plate having a second surface arranged to contact and transfer heat with respect to a second component surface. The first and second component surfaces may be surfaces of the same component, or of different components, and the component(s) may be any device with which heat is to be transferred, such as electronic devices, surfaces of a cold plate or other heat exchanger configuration, and so on. In some embodiments, the second heat transfer surface may face the first heat transfer surface, i.e., generally toward the first heat transfer surface and be oriented so that the second heat transfer surface is arranged at an angle of 90 degrees or less relative to the first heat transfer surface. In other embodiments, the heat transfer surfaces may be arranged at angles up to 180 degrees or more relative to each other. A connecting portion may extend between and connect the first and second heat transfer plates together, with the connecting portion providing compliant support of the first and second heat transfer plates that allows the first and second heat transfer surfaces to be movable toward and away from each other. As an example, the connecting portion may include a bend that extends along an arc of at least 90 degrees so the heat transfer surfaces are arranged facing each other. To provide compliant support of the plates, the connecting portion may provide an elastically deformable section between the heat transfer plates that allows the plates to be moved relative to each other, at least to some extent, without causing plastic deformation of the elastically deformable element. This may allow the connecting portion to exert a bias on the plates, e.g., to urge the plates to move toward each other when the plates are engaged with a component surface. Of course, the connecting portion may have a part that plastically deforms or is plastically deformable when the heat transfer plates are moved relative to each other, and such plastic deformation may be used alone or in combination with elastic deformation. A heat transfer conduit may be arranged to conduct a flow of heat transfer fluid to the first and second heat transfer plates, with the heat transfer conduit including at least one passageway that extends from the first heat transfer plate to the connecting portion, and from the connecting portion to the second transfer plate. Inlet and outlet ports may be arranged to respectively conduct heat transfer fluid into the heat transfer conduit and out of the heat transfer conduit, e.g., so that heat transfer fluid can be circulated to the heat transfer plates to receive heat from the plates. In some cases, the first and second heat transfer plates may each have a side respectively opposite of the first and second heat transfer surfaces that are exposed for contact with heat transfer fluid in the heat transfer conduit, e.g., to transfer heat with respect to the heat transfer fluid.

In some embodiments, the first and second heat transfer plates and at least a part of the connecting portion may be formed as a single unitary part, e.g., the single unitary part may be a metal sheet formed to define the first and second heat transfer plates and at least a part of the connecting portion. The metal sheet may be flat, at least initially, such as at a time when the heat transfer plates and connecting portion are cut from the sheet. In some embodiments, a channel member that at least partially defines the heat transfer conduit and at least a part of the connecting portion may be secured to single unitary part. As an example, the channel member may be secured to the single unitary part such that the single unitary part and the channel member together define at least a portion of the heat transfer conduit. The channel member may be formed as a "blister" element, e.g., a relatively thin sheet material that is bent, stamped or otherwise formed to define concave regions that function as the heat transfer conduit once closed by the single unitary part or other element. In some cases, the channel member and the single unitary part may each have a periphery, and the peripheries of the channel member and the single unitary part may be sealingly joined together, such as by brazing or welding. This attachment of the channel member and the unitary part may enclose the heat transfer conduit portions defined by the channel member, allowing the heat transfer conduit to conduct fluid flow.

In some embodiments, the inlet port is located adjacent the first heat transfer plate, and the outlet port is located adjacent the second heat transfer plate. For example, a channel member may define an inlet and/or outlet port, and the inlet or outlet port may be located adjacent a corresponding heat transfer plate. This may allow fluid that enters the inlet to be directed toward the first heat transfer plate for contact with the plate, and/or fluid that contacts the second heat transfer plate to move directly to the outlet. In some cases, an inlet (or outlet) that is adjacent to a heat transfer plate may be defined at least in part by the heat transfer plate, or the inlet (or outlet) may be defined by another component that is positioned near to the plate, such as a channel member.

The heat transfer conduit may be arranged to conduct flow to the heat transfer plates in a variety of different ways. For example, the heat transfer conduit and the inlet and outlet ports may be arranged such that heat transfer fluid flows from the first heat transfer plate to the second heat transfer plate and back to the first heat transfer plate before exiting the heat transfer conduit via the outlet port. Alternately, fluid may flow from the first heat transfer plate to the second heat transfer plate and then exit via the outlet. In other arrangements, fluid entering an inlet may split with one portion of the fluid flowing to a first heat transfer plate and another portion of the fluid flowing to a second heat transfer plate. Other flow configurations are possible.

As noted above, the heat transfer plates may contact corresponding surfaces of a component, and the plates may be secured relative to each other and/or relative to the corresponding component surface. For example, at least one fastener may urge the first and second heat transfer plates to move toward each other to secure a component between the first and second heat transfer plates. Such a fastener may include a clamp, nut and bolt, bail, hook, bayonet pin, threaded fastener, rivet, or other suitable arrangement.

In another aspect of the invention, a method for forming an assembly for transferring heat with respect to a component includes providing first and second heat transfer plates respectively having first and second surfaces arranged to contact and transfer heat with respect to first and second component surfaces. The first and second heat transfer plates may be connected by a connecting portion extending between the first and second heat transfer plates. In one embodiment, the first and second heat transfer plates are part of a single unitary part that defines the first and second heat transfer plates and at least part of the connecting portion. A channel member may be secured to the unitary part such that the channel member and the unitary part define at least in part a heat transfer conduit that can conduct fluid flow to the heat transfer plates. In some embodiments, the channel member has a concave portion that defines at least in part the heat transfer conduit and a peripheral edge, and the channel member may be secured to the unitary part by sealingly securing the peripheral edge of the channel member to the single unitary part so that the channel member and the single unitary part together enclose the heat transfer conduit.

The connecting portion may be bent so that the second heat transfer surface faces the first heat transfer surface and is arranged at an angle of 90 degrees or less relative to the first heat transfer surface. The bent connecting portion may also provide compliant support of the first and second heat transfer plates that allows the first and second heat transfer surfaces to be movable toward and away from each other, e.g., so the plates can move as needed when contacting a corresponding component surface. A heat transfer conduit mentioned above may be arranged to conduct a flow of heat transfer fluid to the first and second heat transfer plates, with the heat transfer conduit including at least one passageway that extends from the first heat transfer plate to the connecting portion and from the connecting portion to the second transfer plate. Inlet and outlet ports may be arranged to respectively conduct heat transfer fluid into the heat transfer conduit and out of the heat transfer conduit.

These and other aspects of the invention will be apparent from the following description and claims.

### BRIEF DESCRIPTION OF THE DRAWINGS

Aspects of the invention are described with reference to the following drawings in which numerals reference like elements, and wherein:
FIG. 1 shows a perspective view of a wrap around heat exchanger assembly engaged with a component in an illustrative embodiment;
FIG. 2 shows an exploded view of a heat exchanger assembly in an embodiment that includes a channel member and unitary part;
FIG. 3 shows a side view of the FIG. 2 assembly after the channel member and unitary part are joined;
FIG. 4 shows the FIG. 2 assembly after the channel member and unitary part are bent to form a connecting portion with a bend;
FIG. 5 shows an end view of the FIG. 4 assembly and fasteners to secure the heat transfer plates of the assembly to a corresponding component;
FIG. 6 shows a modified version of the FIG. 1 assembly having an integrated fastener arrangement;
FIG. 7 shows a side view of the FIG. 6 embodiment with the integrated fasteners engaged with an opposing side of the assembly;
FIG. 8 shows an illustrative assembly having two connecting portions and three heat transfer plates;
FIG. 9 shows an illustrative assembly having two connecting portions and three heat transfer plates associated with a single component;
FIG. 10 shows an illustrative assembly having inlet and outlet ports extending in a common direction;
FIG. 11 shows a modified version of the FIG. 8 embodiment having heat transfer plates of different length;
FIG. 12 shows a heat exchanger assembly having two pairs of facing heat transfer surfaces in an illustrative embodiment;
FIG. 13 shows a heat exchanger assembly having multiple pairs of heat transfer surfaces;
FIG. 14 shows a heat exchanger assembly having elongated heat transfer surfaces and a connecting portion at an end of the elongated surfaces;
FIG. 15 shows a heat exchanger assembly having multiple pairs of heat transfer plates and connecting portions with bends arranged in different planes
FIG. 16 shows a cross sectional view of a heat exchanger assembly having heat transfer plates molded or otherwise secured to channel member; and
FIG. 17 shows a perspective view of the FIG. 16 embodiment.

### DETAILED DESCRIPTION

Aspects of the invention are not limited in application to the details of construction and the arrangement of components set forth in the following description or illustrated in the drawings. Other embodiments may be employed and aspects of the invention may be practiced or be carried out in various ways. Also, aspects and/or different features of embodiments of the disclosure may be used alone or in any suitable combination with each other. Thus, the phraseology and terminology used herein is for the purpose of description and should not be regarded as limiting.

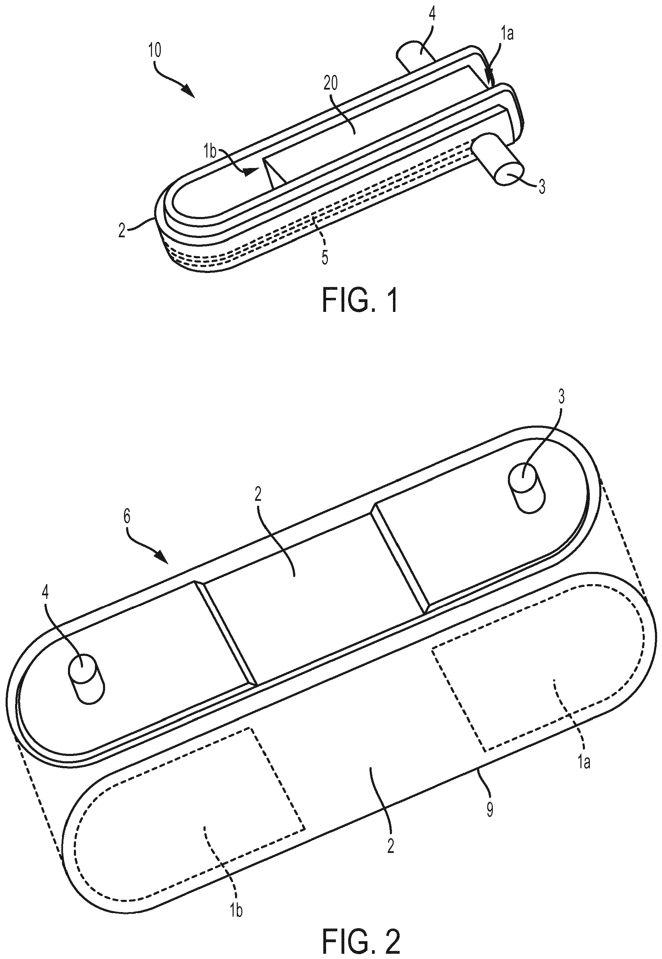

FIG. 1 shows a wrap around heat exchanger assembly 10 for transferring heat with respect to one or more components 20. In this embodiment, the assembly 10 is arranged to engage with and cool two or more heat generating components 20, such as power electronics, computer processors, batteries, and other devices that generate heat. However, use of the assembly 10 for cooling is not required, as any heat transfer may be employed by the assembly 10, including heating of a component 20 by the assembly 10. Thus, a component 20 need not be or include an electronic device, but may be any device requiring cooling and/or heating. The assembly 10 may have a variety of different shapes, sizes or other configurations, some embodiments of which are described below. In this illustrative embodiment of FIG. 1, the assembly 10 includes first and second heat transfer plates 1a and 1b that each have a heat transfer surface that contacts a portion of a component 20. The heat transfer plates 1 may be made of a metal, such as aluminum or copper, or any other suitable material to transfer heat with respect to a component 20. For example, the heat transfer plates 1 may each contact a respective heat generating portion of the component 20 so that heat generated by the component 20 may be received by the plates 1, thereby cooling the component 20. As is known in the art, thermal grease or other thermal coupling agent may be used between the heat transfer surfaces and the component surfaces. In this embodiment, heat transfer plates 1 contact opposite sides of a single component 20, but other arrangements are possible, such as having the first heat transfer plate 1a contact a surface of a first component 20, and having the second heat transfer plate 1b contact a surface of a second component 20 which is stacked on top of the first component 20. Alternately, two or more components 20 may be placed side-by-side so the first and second heat transfer plates 1 contact opposite sides of both components 20.

One feature of the heat exchanger assembly 10 is that the assembly wraps around at least a portion of one or more components 20 that is engaged by the assembly 10. In FIG. 1, the plates 1 are supported by a connecting portion 2 extending between and connecting the first and second heat transfer plates 1a, 1b. The connecting portion 2 may provide compliant support of the first and second heat transfer plates 1a, 1b that allows the first and second heat transfer surfaces to be movable toward and away from each other in an elastic way, i.e., so the heat transfer surfaces can be moved toward or away from each other in the presence of a force, but will recover to a rest position when the force is removed. This compliant support may allow the heat transfer surfaces to move or otherwise adjust in position so that two or more component surfaces can be properly engaged, even if the component surfaces move during heat exchanging operations or are variable in position or shape due to manufacturing tolerances or other characteristics. In this embodiment, the connecting portion 2 supports the heat transfer plates 1 so the plates 1 can be moved apart to receive a component 20 between the plates 1 and/or so the plates 1 can be moved towards each other to engage one or more components 20. For example, the connecting portion 2 may support the plates 1 in an at rest condition so that a distance between the plates 1 is smaller than a dimension of the component 20 to be positioned between the plates. However, the connecting portion 2 may support the plates 1 so the plates can be moved apart to receive the component 20. After the plates 1 are spread apart, the connecting portion 2 may bias the plates 1 to move toward each other with a resilient force, e.g., so that the component 20 may be squeezed by the plates 1. Such an arrangement may provide for convenient engagement of the assembly 10 with a component 20, e.g., because the assembly 10 may engage the component 20 without additional securing structure required. In other embodiments, the plates 1 may be supported by the connecting portion 2 in an at rest condition so that a distance between the plates 1 is greater than a dimension of the component 20 to be positioned between the plates 1. This arrangement may provide for easier positioning of the component 20 between the plates 1 since the plates 1 need not be moved apart. In such an arrangement, the plates 1 may be clamped or otherwise moved toward each other to engage the component 20, e.g., by a clamp or other fastener that engages with the plates 1 and/or the connecting portion 2 to bias the plates 1 to move toward each other, or by fasteners that secure the plates 1 to each other and/or to the component 20. For example, a spring clip may be engaged over the connecting portion 2 and/or over the plates 1 so that the spring clip urges the plates 1 to move toward each other. In another embodiment, a bolt may extend through openings in the plates 1 and/or connecting portion 2 and a nut may be engaged with the bolt to move the plates 1 toward each other and secure the plates 1 to the component 20. Other arrangements are possible, such as adhesive, welding, brazing and other fastener configurations.

The heat exchanger assembly 10 can include a heat transfer conduit 5 to conduct a flow of heat transfer fluid for contact with the heat transfer plates 1. That is, heat may be received from, or provided to, the heat transfer plates 1 by a heat transfer fluid that may be circulated through the assembly 10. As shown in FIG. 1, a heat transfer conduit 5 can include at least one passageway that extends from the first heat transfer plate 1a to the connecting portion 2 and from the connecting portion 2 to the second transfer plate 1b and conducts a flow of heat transfer fluid to and/or between the first and second heat transfer plates 1a, 1b. Inlet and outlet ports 3,4 may be arranged to respectively conduct heat transfer fluid into the heat transfer conduit 5 and out of the heat transfer conduit 5, respectively. The heat transfer fluid may transfer heat with respect to the heat transfer plates 1, e.g., provide heat to and/or receive heat from the plates 1. In some cases, the heat transfer fluid may contact a side of the plates 1 that is opposite a side of the plates that contacts a component 20, i.e., the heat transfer surface. Thus, for example, heat received by a plate 1 from a component on one side of the plate 1 may be transferred by the plate 1 to heat transfer fluid on an opposite side of the plate 1. The fluid may be a gas, liquid, a combination of gas and liquid, or have any other suitable arrangement. The heat transfer conduit 5 may include a plurality of passageways that extend from the inlet to the outlet port 3,4, e.g., for parallel flow of heat transfer fluid in the passageways between the plates 1a,1b, or for serial flow in the passageways between the plates 1a,1b. For example, heat transfer fluid may enter an inlet port 3, and flow to the first heat transfer plate 1a, and then flow to the second heat transfer plate 2b and exit via the outlet port 4. Such flow may be achieved in a single passageway or in multiple passageways that allow for parallel flow from one plate 1 to the other plate 1. In other cases, fluid may flow from the inlet port 3 to the first plate 1a, then to the second plate 1b, then back to the first plate 1a, then back to the second plate 1b, (optionally repeating this flow pattern one or more times) and then exit via the outlet port 4. In this case, the heat transfer conduit 5 may include one or more passageways that provide for serial flow from a first plate 1 to a second plate 1, back to the first plate 1, then to the second plate 1, and so on. Heat exchanger assemblies 10 are not limited to just this type of fluid flow, however. In other arrangements, fluid may enter the inlet port 3 and flow either to the first plate 1a or the second plate 1b, e.g., the heat transfer conduit 5 may split flow of the incoming fluid at the inlet 3 so some fluid flows directly to the first plate 1a and other fluid flows directly to the second plate 1b. Thereafter, the fluid may exit via an outlet port 4. Other flow arrangements are possible and will be appreciated by those of skill in the art. As yet a further example, an assembly 10 is not limited to one inlet port 3 and one outlet port 4, and instead may have any suitable number of such ports 3,4 and the ports 3,4 may be positioned in any suitable way or location on the assembly 10, including on the connecting portion 2. For example, each heat transfer plate 1 may have a corresponding inlet 3, outlet 4 and heat transfer conduit 5, e.g., so fluid enters the inlet 3, contacts the plate 1 only, and then exits via the outlet 4. In this case, the connecting portion 2 may provide only mechanical support and connection between the plates 1, with no heat transfer conduit 5 extending along the connecting portion 2. In yet another arrangement, an inlet 3 may be provided at the connecting portion 2, and incoming fluid flow may be split so a portion of the fluid flows to a first heat transfer plate 1a, and another portion of the fluid flows to a second heat transfer plate 1b. Outlets 4 may be provided adjacent each heat transfer plate 1, e.g., in a way like that shown in FIG. 1 where the inlet 3 adjacent the first heat transfer plate 1a functions as an outlet rather than an inlet. As is known in the art, once the heat transfer fluid is removed from the assembly 10, heat may be removed from or provided to the fluid in any suitably way, such as by a refrigeration system, heat exchangers, ice bath, electrical resistance heating elements, etc., and the fluid may be circulated back to the assembly 10.

One feature of the heat exchanger assembly 10 is that the heat transfer surface of one heat transfer plate, e.g., the second heat transfer plate 1b in FIG. 1, faces the heat transfer surface of another heat transfer plate, e.g., the first heat transfer plate 1a, and may be arranged at an angle of 90 degrees or less relative to the first heat transfer surface. In the FIG. 1 embodiment, the heat transfer surfaces of the heat transfer plates 1a, 1b are arranged at an angle of about 0 degrees relative to each other, e.g., an angle of 5 degrees or less. A configuration where the plates 1a, 1b are spaced apart and in generally parallel planes (i.e., at an angle of about 0 to 5 degrees to each other) may allow the assembly 10 to sandwich a component 20 that has heat generating surfaces on opposite, parallel sides of the component 20. However, an assembly 10 may be arranged in other ways to engage other component 20 surface configurations. For example, a component 20 may have heat generating surfaces arranged at an angle of 5 to 90 degrees to each other. In such a case, an assembly 10 may have first and second heat transfer plates 1a, 1b that have heat transfer surfaces arranged at about 5 to 90 degrees to each other so that each plate 1a, 1b may contact a corresponding heat generating surface of the component 20. As an example, the connecting portion 2 in the FIG. 1 embodiment may support the heat transfer plates 1a,1b so that their heat transfer surfaces face each other and are arranged at an angle of 45 degrees to each other so the heat transfer surfaces can engage with surfaces of a component 20 that are at an angle of 45 degrees. In some cases, the plates 1a, 1b may be supported by the connecting portion 2 so the heat transfer surfaces are at an angle less than that of the component surfaces, e.g., so that the plates 1a, 1b may squeeze or resiliently contact the heat generating surfaces of the component 20 when the assembly is engaged with the component 20. Alternately, or in addition, a clamp or other fastener may be used to secure the plates 1a, 1b to the component 20.

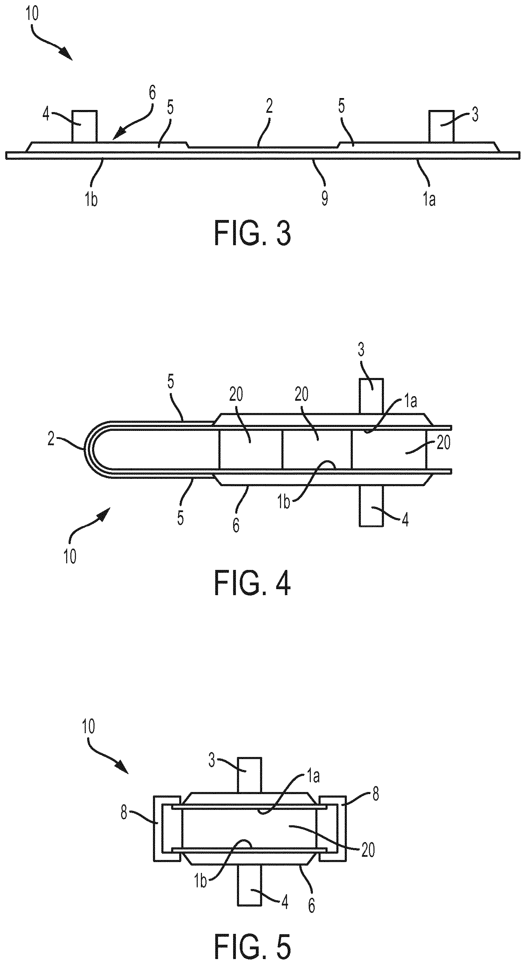

The assembly 10 of FIG. 1 may be constructed in various different ways, and FIGs. 2-5 illustrate one possible arrangement. FIG. 2 shows an exploded view of an assembly 10 that may ultimately be configured like that in FIG. 1. In this embodiment, the first and second heat transfer plates 1a, 1b and at least a part of the connecting portion 2 are formed as a single unitary part 9. For example, the single unitary part 9 may be a flat metal sheet formed to define the first and second heat transfer plates 1a, 1b and at least a part of the connecting portion 2. The metal sheet material may be die cut or otherwise formed to have the desired shape for the plates 1a, 1b and the connecting portion 2 and then mated with another part to define the heat transfer conduit 5 and inlet and outlet ports 3,4. In this embodiment, a channel member 6 is arranged to mate with the unitary part 9 and to at least partially define the heat transfer conduit 5 and at least a part of the connecting portion 2. For example, the channel member 6 may be formed from a sheet material that is bent, stamped or otherwise shaped to define one or more concave sections or "blisters" that define part of the heat transfer conduit 5. Elements arranged in this way to provide a fluid passageway by bending or otherwise forming a relatively thin sheet material are described in more detail in US Patents 6661658 and 8616267, which are hereby incorporated by reference. In other arrangements, the channel member 6 may be cut, ground, skived or otherwise machined to have material removed so as to define the heat transfer conduit 5. The channel member 6 may be secured to the single unitary part 9 such that the single unitary part and the channel member together define or enclose at least a portion of the heat transfer conduit 5. For example, the channel member 6 and the single unitary part 9 may each have a periphery, and the peripheries of the channel member 6 and the single unitary part 9 may be sealingly joined together, e.g., by brazing, welding, adhesive, fasteners, etc., e.g., as shown in FIG. 3. As can be seen in FIGs. 2 and 3, the channel member 6 may include the inlet and outlet ports 3,4 and the channel member 6 may extend from the first heat transfer plate 1a to the second heat transfer plate 1b along the connecting portion 2.

After the channel member 6 is secured to the unitary part 9 that defines the heat transfer plates 1, the channel member 6 and the unitary part 9 may be bent to form an arrangement like that in FIG. 4. By making the channel member 6 and the unitary part 9 as generally flat members that are joined together and then bent, manufacture and assembly may be made easier and less costly. Alternately, the channel member 6 and unitary part 9 may be bent before being assembled together, and the bent parts joined together, e.g., to enclose and define the heat transfer conduit 5. It should be understood, however, that not all embodiments need have the connecting portion 2 mechanically bent, whether before or after component parts are joined together to form the connecting portion 2. Instead, the connecting portion 2 may be molded (e.g., of a polymer material, which may include a rubber, elastomer, thermoset, thermoplastic, fiber reinforced polymer, and other materials or combinations of materials), machined from a block, or otherwise formed to have a desired curved or otherwise bent shape. As one example, heat transfer plates 1 may be formed of metal sheets that are placed into a molding cavity and co-molded with a polymer material that forms the connecting portion 2, heat transfer conduit 5 and inlet and outlet ports 3,4. Thus, a bend feature of a connecting portion 2 need not be formed by a mechanical bending process, but rather a component that includes a bend may be molded, machined or otherwise formed to have the bend without mechanical bending.

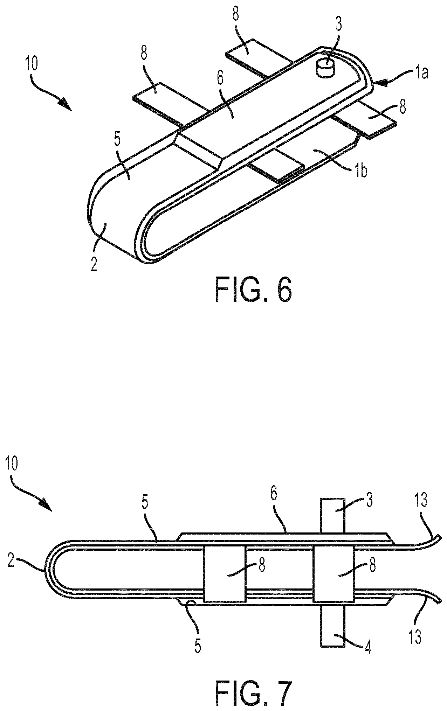

With the assembly 10 suitably formed, the heat transfer plates 1 may be engaged with one or more components 20, e.g., as shown in FIGs. 4 and 5. In this embodiment, three components 20 are sandwiched between the first and second heat transfer plates 1a, 1b, but any suitable number of components 20 may be employed. Also, in this embodiment, one or more clamps 8 are arranged to engage with the peripheries of the channel member 6 and the heat transfer plates 1 so as to clamp the components 20 between the plates 1. However, other fastener arrangements are possible as discussed above, such as screw-type or other fasteners, adhesive, welding, etc. For example, peripheral portions of the first and second heat transfer plates 1a,1b may each have a hole or other opening through which a bolt, spring pin, bayonet pin or other fastener can extend to secure the plates 1 relative to each other and to a component 20. FIGs. 6 and 7 show yet another embodiment in which one or more fasteners 8 are formed integrally with or otherwise attached to a heat exchanger assembly 10. In this illustrative embodiment, the fasteners 8 are straps, arms, hooks or bails that extend outwardly from the first heat transfer plate la. In some cases, the fasteners 8 may be formed integrally with the heat transfer plate 1a, e.g., may be cut from a sheet material with the heat transfer plate 1a. Of course, other options are possible, including separately forming and connecting the fasteners 8 to the assembly 10, such as by welding, adhesive, etc. As can be seen in FIG. 7, the fasteners 8 can be extended from the first heat transfer plate 1a to the second heat transfer plate 1b, e.g., after a component 20 is positioned between the plates 1. The fasteners 8 may engage with the second heat transfer plate 1b (either directly or indirectly via a part of an adjacent channel member 6) in any suitable way. For example, the fasteners 8 in FIG. 7 may be bent to form a hook that captures part of the second heat transfer plate 1b or other assembly portion 10 (such as the outlet 4). Or the fasteners 8 may be welded, brazed or adhered, secured by threaded fastener, and so on. In some cases, fasteners 8 may be provided for both heat transfer plates 1a,1b, and the fasteners 8 may be secured to each other, e.g., in a buckle and strap arrangement, by welding or screwing the straps to each other, and so on.

Also shown in FIG. 7 are ramp features 13 that extend from short sides of the heat transfer plates 1a, 1b. The ramps 13 may aid in positioning a component 20 between the heat transfer plates 1a,1b, particularly if the assembly 10 is formed so that a distance between the plates 1 is less than a dimension of a component 20 to be positioned between the plates. In such a case, the ramps 13 may allow the assembly 10 to be pushed onto the component 20 so the ramps 13 contact the component 20 and urge the plates 1 away from each other to allow the component 20 to be positioned between the plates 1. The ramps 13 may be provided in any suitable way, such as formed integrally with the plates 1 as shown, or formed separately and attached to the plates 1, or provided as an unattached element that is used to engage a component 20 and then removed after use. Also, ramps 13 may be provided on any part or parts of an assembly 10, not just on the short side of heat transfer plates 1 as shown.

As mentioned above, assemblies 10 that include inventive features can be made in a variety of ways, and so need not be made as illustrated in FIGs. 1-7. As an additional example, the heat transfer plates 1 may themselves include an inlet and/or outlet port 3,4 and/or may define at least a part of the heat transfer conduit 5. For example, the plates 1 may include internal channels to define at least parts of the heat transfer conduit 5, and each plate 1 may have an inlet 3 and/or outlet 4 to conduct flow of fluid into or out of the internal channels. To provide for flow from a first plate 1 to a second plate 1 that has a heat transfer surface facing the heat transfer surface of the first plate 1, the internal channels of the plates 1 may be fluidly coupled by a connecting portion 2 that includes one or more passageways. For example, the connecting portion 2 may be formed by one or more tubes that are mechanically and fluidly coupled to the plates 1 so that the tubes provide a fluid connection for the heat transfer conduit 5 as well as mechanical support for the plates 1.

Although the embodiments above show arrangements in which the assembly 10 includes only two heat transfer plates 1, two or more such plates 1 may be provided whether in a one or more planar arrays or arranged in one or more planes or other surfaces. Also, the plates 1 need not have flat surfaces on one or opposite sides, and may be arranged as desired. For example, a side of the heat transfer plates 1 that contacts the heat transfer fluid may include pins, fins, grooves or other structure to help increase a surface area of the plate 1 and thus aid in heat transfer with the heat transfer fluid. As another example, a side of the plates 1 that contacts a component 20 (a heat transfer surface) may include dimples, grooves, raised structures, pins, fins, and/or other structure to engage with a component 20. Such structure may help increase a contact area, and thus aid in heat transfer, or may provide other functions such as helping to secure the component 20 to the plate 1.

Although heat may be transferred between heat transfer plates 1 and the heat transfer fluid as discussed above, the connecting portion 2 and portion of the heat transfer conduit 5 at the connecting portion 2 may be arranged to transfer heat in any suitable way. For example, the connecting portion 2 may be arranged to receive heat from the heat transfer fluid and release that heat to an exterior environment, e.g., by receiving heat from the fluid that is then releasing the heat via fins, pins or other structure on the connecting portions 2 to air or other external environmental features. As another example, the connecting portion 2 may be arranged to reduce heat transfer between the fluid and the connecting portion 2. For example, the heat transfer conduit 5 and/or the connecting portion 2 may be thermally insulated or made of a thermally insulating material to reduce heat transfer between the heat transfer fluid and the connecting portion 2, and/or between the connecting portion 2 and an exterior environment. In yet another embodiment, a flow rate of fluid and/or a cross sectional area of the heat transfer conduit 5 may be arranged as desired in the connecting portion 2 to achieve desired flow rate, heat transfer or other characteristics. In one embodiment, the heat transfer conduit 5 in a part of the connecting portion 2 may have a smaller cross sectional area than in areas near the heat transfer plates 1. This feature can be seen in FIGs. 3 and 4, for example. The smaller cross sectional area at the connecting portion 2 may have different desired effects, such as helping increase (or decrease) a flow rate of heat transfer fluid in the connecting portion 2, increasing (or decreasing) a contact area between the heat transfer fluid and the connecting portion 2, increasing (or decreasing) turbulence of flow through the connecting portion 2, increasing (or decreasing) resistance to flow, and so on. In some embodiments, the process of bending the connecting portion 2 (e.g., formed by a channel member 6 and unitary part 9 as in FIG. 2) may narrow the heat transfer conduit 5 in the connecting portion 2. Standoff elements, such as ribs, fins or walls may be provided between the channel member 6 and the unitary part 9 in the connecting portion 2 to help the heat transfer conduit 5 have a minimum or defined dimension in at least one direction (e.g., a radial direction in relation to the curve of the bend). Alternately, the heat transfer conduit 5 in a part of the connecting portion 2 may have a larger cross sectional area than in areas near the heat transfer plates 1. These arrangements may be used to influence various features, such as fluid flow rate, heat transfer, and so on, and may be varied as desired.

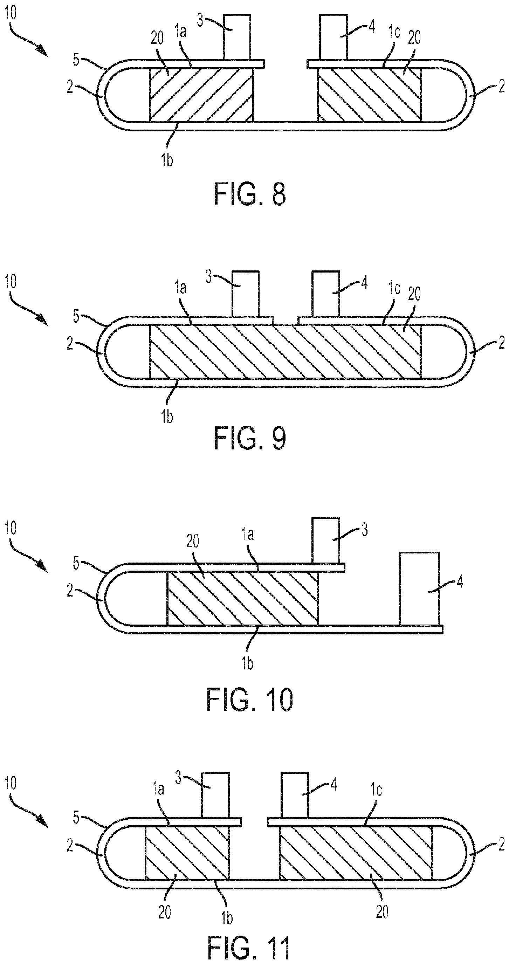

As discussed above, assemblies 10 may be arranged in ways other than that shown in FIGs. 1-7. For example, FIGs. 8-11 show alternatives of the FIG. 1-7 embodiments. FIG. 8 shows an assembly that includes two connecting portions 2 and three heat transfer plates 1a, 1b and 1c. While the embodiment in FIG. 8 is shown employed with two components 20, it may be used with two or more components 20 as shown in FIG. 9. FIGs. 8 and 9 also share the feature that the inlet 3 and outlet 4 are arranged on a same side of the assembly 10 and extend in a same general direction, which may provide for easier connection to a heat transfer fluid supply. FIG. 10 shows another embodiment with inlet 3 and outlet 4 that extend in a same direction, but in this case the outlet 4 is arranged on the second heat transfer plate 1b rather than on a channel member 6 or other similar element. FIG. 10 also has heat transfer plates 1 with different sizes, e.g., length, area, width, etc. Heat exchange assemblies are not limited to arrangements having heat transfer plates 1 of similar size or other configuration details. FIG. 11 shows another modification of the FIG. 8 embodiment where a first heat transfer plate 1a is shorter than a third heat transfer plate 1c. As noted above, heat transfer plates 1 may be arranged in any suitable way relative to each other. As with other embodiments, the embodiments in FIGs. 8-11 may be made in a way similar to that shown in FIGs. 2-5 or in any other suitable way.

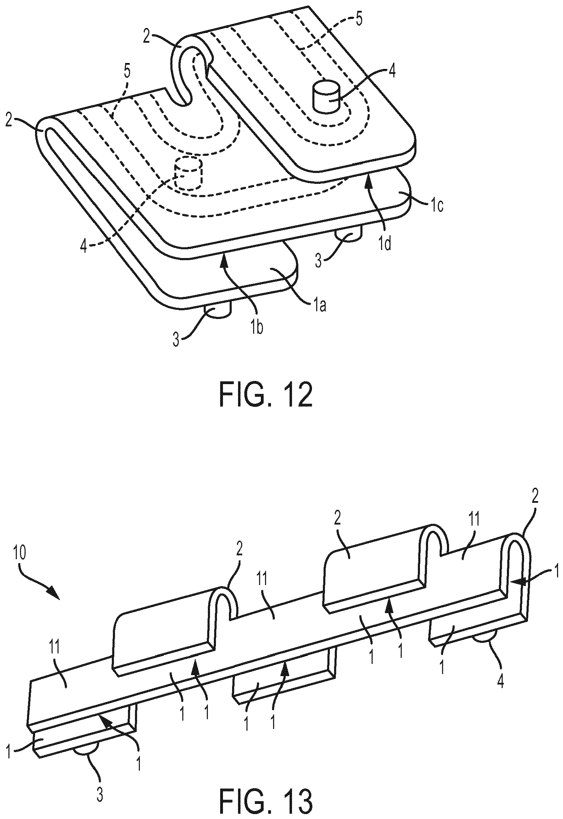

Embodiments above are configured to operate with components 20 arranged in a same general plane, but heat exchange assemblies 10 are not limited to such configurations. For example, FIG. 12 shows an assembly 10 that includes two pairs of opposed or otherwise facing heat transfer plates 1a and 1b, and 1c and 1d, and one or more components 20 may be positioned between the heat transfer plates 1a, 1b, and another one or more components 20 in a different plane may be positioned between the heat transfer plates 1c, 1d. Moreover, although this embodiment shows heat transfer plates 1 with heat transfer surfaces arranged in parallel planes, plates 1 and/or heat transfer surfaces may be arranged at non-zero angles relative to each other. As shown, an inlet 3 may be provided adjacent a first heat transfer plate 1a, and an outlet 4 may be provided adjacent a fourth heat transfer plate 1d, but other configurations are possible. For example, additional inlets 3 and outlets 4 may be provided as shown in dashed line in FIG. 12, i.e., an additional outlet 4 positioned adjacent the second heat transfer plates 1b, and an additional inlet 3 positioned adjacent the third heat transfer plates 1c. In such a case, the heat transfer conduit 5 need not extend between the second and third plates 1b,1c as shown, but instead each pair of plates 1a,1b and 1c,1d may have a corresponding heat transfer conduit 5 that do not communicate with each other. Of course, other inlet and outlet 3, 4 arrangements are possible. Connecting portions 2 may provide compliant support of the plates 1a-1d so that a component 20 can be squeezed between pairs of plates 1a, 1b or 1c, 1d by a resilient force. Alternately, one or more clamps, fasteners or other structure may engage the plates 1 to force the pairs of plates 1a, 1b or 1c, 1d to move toward each other. The assembly 10 may be made in a way like that shown in FIGs. 2-5, e.g., a first metal sheet may be arranged to form the first and second heat transfer plates 1a, 1b as well as a channel member 6 for the third and fourth heat transfer plates 1c, 1d, and a second metal sheet may be arranged to form the third and fourth heat transfer plates 1c, 1d as well as a channel member 6 for the first and second heat transfer plates 1a, 1b. The two metal sheets may be secured together at peripheries, and then bent to form the two connecting portions 2 in a way similar to that described above. Of course, other assembly arrangements may be used to form the assembly 10 in FIG. 12. For example, two separate assemblies arranged similar to that in FIGs. 2-5 may be constructed, and the two assemblies joined together to form the assembly 10 of FIG. 12.

FIG. 13 shows a modified version of the FIG. 12 embodiment that includes five pairs of opposed or otherwise facing heat transfer plates 1, although other numbers of pairs of plates 1 can be employed. As with the FIG. 12 embodiment, one or more components 20 may be positioned between a corresponding pair of plates 1, and the plates 1 may be engaged with a corresponding component 20 by a resilient force exerted on the plates by the connecting portion 2, one or more fasteners, etc. that urge the plates 1 to move toward each other. It is also possible that the assembly 10 includes one or more heat transfer plates 1 that do not have an opposed or otherwise facing plate 1. For example, portions of the assembly indicated by the reference number 11 in FIG. 13 may function as a heat transfer plate 1, e.g., for contact and heat transfer with one side of a component 20. In such a case, the unpaired heat transfer plates 11 may be associated with an unpaired heat transfer plate 11 of another assembly 10 such that the two unpaired heat transfer plates 11 can sandwich one or more corresponding components 20. Such a configuration can be formed by stacking two FIG. 13 assemblies one on another. A clamp, adhesive, or other fastener may be used to engage the unpaired heat transfer plates 11 with a corresponding component 20. In this embodiment, a single inlet 3 and single outlet 4 are used to cause heat transfer fluid to flow into the heat transfer conduit 5, but any other suitable number and/or arrangement of inlets and/or outlets may be used.

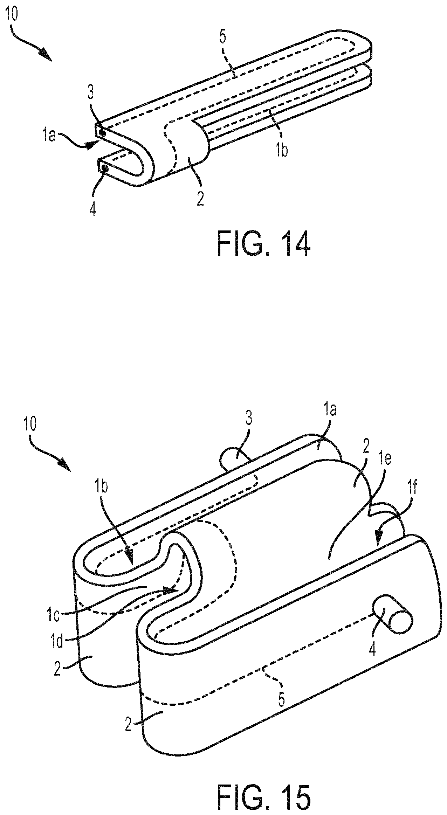

In the embodiments of FIGs. 1 and 2-5, the heat transfer plates 1 have a rectangular shape having a long side and a short side, and the connecting portion 2 is located at the short side of the heat transfer plates 1. This type of arrangement is not required, however, and the connecting portion 2 may be arranged in any suitable way relative to the heat transfer plates 1. For example, FIG. 14 shows an embodiment in which a connecting portion 2 is located along a long side of heat transfer plates 1 that have an elongated rectangular shape. While this embodiment locates the connecting portion 2 at one end of the plates 1, the connecting portion 2 can be located in any suitable place, and may extend along the entire length of the heat transfer plates 1. In addition, the heat transfer plates 1 in embodiments herein are not limited to rectangular shapes as shown, but instead may have a circular, oval, square, triangular, irregular or other shape. This embodiment of FIG. 14 also includes an inlet 3 and outlet 4 that are located at an end of a heat transfer plate 1 and are arranged to introduce or receive heat transfer fluid into or from the heat transfer conduit 5 in a direction generally in a plane of, or along a length of, the adjacent heat transfer plate 1. Also, in this embodiment, the heat transfer conduit 5 is arranged to cause heat transfer fluid to flow initially along a length of a first heat transfer plate 1a, reverse direction at an end opposite the inlet 3 and flow back along a length of the first heat transfer plate 1a to the connecting portion 2. The fluid may flow from the connecting portion 2 along a length of the second heat transfer plate 1b, reverse direction at an end of the plate 1 opposite the outlet 4, and then flow along a length of the second heat transfer plate 1b to the outlet 4. Of course, other flow arrangements are possible.

FIG. 15 shows yet another embodiment that includes three pairs of opposed or otherwise facing heat transfer plates 1a,1b and 1c,1d and 1e,1f. In this assembly 10, first and third connecting portions 2 are arranged at the short side of two pairs of heat transfer plates 1a, 1b and 1e,1f, and a second connecting portion 2 is arranged at the long side of a pair of heat transfer plates 1c,1d. While the heat transfer plates 1 are arranged in generally parallel planes, the first and third connecting portions 2 have bends with radii that extend in a horizontal plane and the second connecting portion 2 has a bend with radii that extend in a vertical plane. As in other embodiments, inlet and outlet ports 3,4 may be arranged in any suitable way, and in this embodiment an inlet 3 is adjacent a first heat transfer plate 1a and an outlet 4 is adjacent a sixth heat transfer plate If. The heat transfer conduit 5 is arranged to conduct flow of heat transfer fluid from the inlet 3 and so the fluid flows past the first heat transfer plate 1a, to the first connecting portion 2, then to the second and third heat transfer plates 1b, 1c, then to the second connecting portion 2, then to the fourth and fifth heat transfer plates 1d,1e, then to the third connecting portion 2, and to the sixth heat transfer plate If and the outlet 4. The assembly 10 may be constructed in any suitable way, e.g., a first metal sheet may be formed to define the first, second, fifth and sixth heat transfer plates 1 as well as part of the connecting portions 2, and a second metal sheet may be formed to define the third and fourth heat transfer plates 1 as well as part of the connecting portions 2 and the inlet 3 and outlet 4. These two metal sheets may be joined together to define the heat transfer conduit 5 that extends from the inlet 3 to the outlet 4, e.g., a gap may be defined between the two metal sheets to define a passageway for the heat transfer conduit 5. Before or after being joined together, the metal sheets may be bent to form the shape shown in FIG. 15. While the connecting portions 2 in this embodiment have bends that extend along 180 degrees, other arc extensions are possible, such as 90 degrees or less.

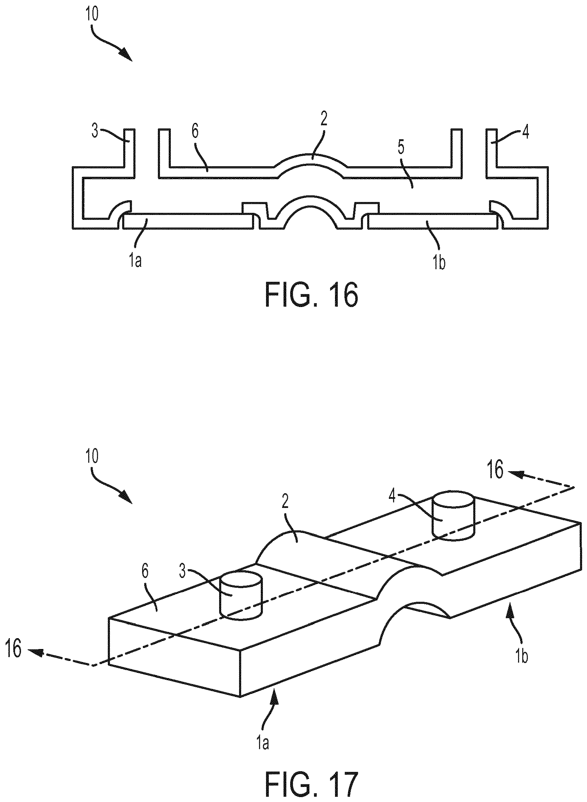

For example, FIGs. 16 and 17 show a heat exchanger assembly 10 that has a connecting portion 2 having a bend that supports heat transfer plates 1a, 1b so the heat transfer surfaces are arranged at an angle of about 180 degrees relative to each other. Other arrangements are possible, including angles between 0 degrees like that shown in FIG. 1 up to and including 180 degrees as shown in FIGs. 16 and 17 or more. Also in this embodiment, the heat transfer plates 1a, 1b are secured to a channel member 6 that defines the connecting portion 2, inlet 3, outlet 4 and heat transfer conduit 5. Although other configurations are possible, the channel member 6 is arranged with a pair of openings into which the heat transfer plates 1a, 1b are received. The heat transfer plates 1a, 1b may be metallic elements, e.g., metal sheet portions, that are adhered, welded, or otherwise secured to the channel member 6 at the openings. In some embodiments, the heat transfer plates 1a, 1b may be co-molded with a channel member 6, e.g., by placing metal sheet portions in a mold or other form in which polymer material is injected or otherwise introduced to form the channel member 6 and secure the channel member 6 to the plates 1a, 1b. Other arrangements are possible though, such as forming the channel member 6 separately from the plates 1a, 1b, and then securing the plates 1a, 1b to the channel member 6 at the corresponding openings. The plates 1a, 1b may be sealingly secured to the channel member 6 to help prevent heat transfer fluid in the heat transfer conduit 5 from leaking. In other embodiments, the channel member 6 may be formed in a way similar to that in FIGs. 2-3 (e.g., of a formed metal sheet or molded polymer material), and the heat transfer plates 1a, 1b may be formed from a single metal sheet that is secured to the channel member 6. In this embodiment, the connecting portion 2 includes a bend that extends along an arc of about 30 to 90 degrees, although other bend arcs are possible, e.g., up to and including bend arcs of 270 degrees. Note that an arc along which a bend of the connecting portion 2 extends need not correspond to an angle at which the heat transfer surfaces are arranged with respect to each other. For example, the connecting portion in FIG. 1 has a bend that extends along an arc of about 180 degrees while the heat transfer surfaces are arranged at a 0 degree angle relative to each other. However, the bend could extend along other arc lengths, such as 200 degrees or more. As with other embodiments, the connecting portion 2 may provide elastic and/or plastic support to the plates 1a, 1b, i.e., a part of the connecting portion 2 may allow for the plates 1a, 1b to be moved relative to each other with corresponding elastic and/or plastic deformation of a part of the connecting portion 2.

The indefinite articles "a" and "an," as used herein in the specification and in the claims, unless clearly indicated to the contrary, should be understood to mean "at least one."

The phrase "and/or," as used herein in the specification and in the claims, should be understood to mean "either or both" of the elements so conjoined, i.e., elements that are conjunctively present in some cases and disjunctively present in other cases. Multiple elements listed with "and/or" should be construed in the same fashion, i.e., "one or more" of the elements so conjoined. Other elements may optionally be present other than the elements specifically identified by the "and/or" clause, whether related or unrelated to those elements specifically identified.

The use of "including," "comprising," "having," "containing," "involving," and/or variations thereof herein, is meant to encompass the items listed thereafter and equivalents thereof as well as additional items.

It should also be understood that, unless clearly indicated to the contrary, in any methods claimed herein that include more than one step or act, the order of the steps or acts of the method is not necessarily limited to the order in which the steps or acts of the method are recited.

While aspects of the invention have been described with reference to various illustrative embodiments, such aspects are not limited to the embodiments described. Thus, it is evident that many alternatives, modifications, and variations of the embodiments described will be apparent to those skilled in the art. Accordingly, embodiments as set forth herein are intended to be illustrative, not limiting.

## Claims

1. An assembly (10) for transferring heat with respect to a component (20), comprising:
a first heat transfer plate (1a) having a first heat transfer surface arranged to contact and transfer heat with respect to a first component surface;
a second heat transfer plate (1b) having a second heat transfer surface arranged to contact and transfer heat with respect to a second component surface and arranged at an angle of 270 degrees or less relative to the first heat transfer surface;
a connecting portion (2) extending between and connecting the first and second heat transfer plates together, the connecting portion including a bend that extends along an arc of at least 30 degrees;
a heat transfer conduit (5) arranged to conduct a flow of heat transfer fluid to the first and second heat transfer plates, the heat transfer conduit including at least one passageway that extends from the first heat transfer plate to the connecting portion and from the connecting portion to the second transfer plate;
the heat transfer conduit having a cross sectional area in a part of the connecting portion that is different from a cross sectional area near the first and second heat transfer plates; and
inlet and outlet ports (3, 4) arranged to respectively conduct heat transfer fluid into the heat transfer conduit and out of the heat transfer conduit,
**characterised in that** the heat transfer conduit (5) has a cross sectional area in a part of the connecting portion (2) that is either smaller or larger from a cross sectional area at the first and second heat transfer plates (1a,1b).

2. The assembly (10) of claim 1, wherein the connecting portion is arranged to provide compliant support of the first and second heat transfer plates that allows the first and second heat transfer surfaces to be movable toward and away from each other.

3. The assembly (10) of claim 1 or 2, wherein the first and second heat transfer plates (1a, 1b) and at least a part of the connecting portion (2) are formed as a single unitary part (9), the single unitary part preferably being a metal sheet formed to define the first and second heat transfer plates (1a, 1b) and at least a part of the connecting portion (2).

4. The assembly (10) of claim 3, further comprising a channel member (6) that at least partially defines the heat transfer conduit (5) and at least a part of the connecting portion (2), the channel member being secured to the single unitary part (9).

5. The assembly (10) of claim 4, further comprising standoff elements between the channel member (6) and the single unitary part (9) in the connection portion (2) to define a dimension of the heat transfer conduit (5).

6. The assembly (10) of claim 5, wherein:
the channel member (6) and the single unitary part (9) each have a periphery, wherein the peripheries of the channel member and the single unitary part are sealingly joined together; and/or
the channel member is formed from a sheet material that is bent to define a convex section that defines part of the heat transfer conduit.

7. The assembly (10) of any one of the preceding claims, wherein
the inlet port (3) is located adjacent the first heat transfer plate (1a), and the outlet port (4) is located adjacent the second heat transfer plate (1b); and/or
the assembly further comprises a channel member (6) that defines at least a portion of the heat transfer conduit (5) and the inlet and outlet ports, the channel member extending from the first heat transfer plate to the second heat transfer plate along the connecting portion (2), the channel member optionally being sealingly engaged with the connecting portion such that the channel member and the connecting portion together define at least a portion of the heat transfer conduit.

8. The assembly (10) of any one of the preceding claims, wherein
the heat transfer conduit (5) and the inlet and outlet ports (3, 4) are arranged such that heat transfer fluid flows from the first heat transfer plate (1a) to the second heat transfer plate (1b) and back to the first heat transfer plate before exiting the heat transfer conduit via the outlet port; and/or
the first and second heat transfer plates each have a side respectively opposite of the first and second heat transfer surfaces that are exposed for contact with heat transfer fluid in the heat transfer conduit.

9. The assembly (10) of any one of the preceding claims, further comprising at least one fastener (8) that urges the first and second heat transfer plates (1a, 1b) to move toward each other to secure a component (20) between the first and second heat transfer plates, wherein the at least one fastener is optionally formed integrally with the first heat transfer plate

10. The assembly (10) of any one of the preceding claims, wherein the connecting portion (2) includes a bend that extends along an arc of at least 90 degrees.

11. The assembly (10) of any one of the preceding claims, wherein
the first and second heat transfer surfaces are planar; and/or
the heat transfer surfaces are defined by metallic elements, and the connecting portion (2) and heat transfer conduit (5) are formed at least in part by a polymer element, wherein the metallic elements are preferably co-molded with or bonded to the polymer element; and/or
the heat transfer plates (1a, 1b) are each formed of a metallic element and the heat transfer plates are molded with a polymer element that defines at least in part the connecting portion, the inlet port (3), the outlet port (4) and/or the heat transfer conduit.

12. A method for forming an assembly (10) for transferring heat with respect to a component (20), comprising:
providing first and second heat transfer plates (1a, 1b) respectively having first and second surfaces arranged to contact and transfer heat with respect to first and second component surfaces, the first and second heat transfer plates being connected by a connecting portion (2) extending between the first and second heat transfer plates;
bending the connecting portion (2) so that the second heat transfer surface faces the first heat transfer surface and is arranged at an angle of at least 30 degrees relative to the first heat transfer surface, the bent connecting portion providing compliant support of the first and second heat transfer plates that allows the first and second heat transfer surfaces to be movable toward and away from each other; and
providing a heat transfer conduit (5) arranged to conduct a flow of heat transfer fluid to the first and second heat transfer plates, the heat transfer conduit including at least one passageway that extends from the first heat transfer plate to the connecting portion and from the connecting portion to the second heat transfer plate, **characterised in that**
the heat transfer conduit 1 has cross sectional area in a part of the connecting portion that is either smaller or larger from a cross sectional area at the first and second heat transfer plates.

13. The method of claim 12, further comprising:
providing inlet and outlet ports (3, 4) arranged to respectively conduct heat transfer fluid into the heat transfer conduit (5) and out of the heat transfer conduit.

14. The method of claim 12 or 13, wherein
the step of providing the heat transfer conduit (5) comprises securing a channel member (6) to the connecting portion (2) such that the channel member and the connecting portion together define at least in part the heat transfer conduit, wherein standoff elements are provided between the channel member (6) and the single unitary part (9) in the connection portion (2) to define a dimension of the heat transfer conduit (5); and/or
the step of securing the channel member to the connecting portion is performed before the step of bending the connecting portion, and the step of bending the connecting portion includes bending the channel member; and/or
the step of bending the connecting portion includes bending a part of the connecting portion to form a bend that extends along at least 90 degrees.

15. The method of any one of claims 12 to 14, wherein the step of providing the first and second heat transfer plates (1a, 1b) includes providing a single unitary part that defines the first and second heat transfer plates and the connecting portion (2), wherein the channel member (6) optionally has a convex portion that defines at least in part the heat transfer conduit (5) and a peripheral edge and the step of securing the channel member to the connecting portion includes sealingly securing the peripheral edge of the channel member to the single unitary part such that the channel member and the single unitary part together define the heat transfer conduit.

## Patentansprüche

1. Montage (10) zum Übertragen von Wärme in Bezug auf ein Bauteil (20), die umfasst:
eine erste Wärmeübertragungsplatte (1a), die eine erste Wärmeübertragungsoberfläche aufweist, die eingerichtet ist, um eine erste Bauteiloberfläche zu berühren und Wärme zu ihr zu übertragen;
eine zweite Wärmeübertragungsplatte (1b), die eine zweite Wärmeübertragungsoberfläche aufweist, die eingerichtet ist, um eine zweite Bauteiloberfläche zu berühren und Wärme zu ihr zu übertragen, und die in einem Winkel von 270 Grad oder weniger zu der ersten Wärmeübertragungsoberfläche eingerichtet ist;
einen Verbindungsabschnitt (2), der sich zwischen der ersten und der zweiten Wärmeübertragungsplatte erstreckt und sie miteinander verbindet, wobei der Verbindungsabschnitt eine Biegung beinhaltet, die sich entlang eines Bogens von mindestens 30 Grad erstreckt;
eine Wärmeübertragungsleitung (5), die eingerichtet ist, um einen Fluss von Wärmeübertragungsfluid zu der ersten und der zweiten Wärmeübertragungsplatte zu leiten, wobei die Wärmeübertragungsleitung mindestens eine Passage beinhaltet, die sich von der ersten Wärmeübertragungsplatte zu dem Verbindungsabschnitt und von dem Verbindungsabschnitt zu der zweiten Wärmeübertragungsplatte erstreckt;
wobei die Wärmeübertragungsleitung eine Querschnittfläche in einem Teil des Verbindungsabschnitts aufweist, die von einer Querschnittfläche nahe der ersten und der zweiten Wärmeübertragungsplatte unterschiedlich ist; und
einen Einlass- und einen Auslassanschluss (3, 4), die jeweils eingerichtet sind, um Wärmeübertragungsfluid in die Wärmeübertragungsleitung und aus der Wärmeübertragungsleitung heraus zu leiten,
**dadurch gekennzeichnet, dass** die Wärmeübertragungsleitung (5) eine Querschnittfläche in einem Teil des Verbindungsabschnitts (2) aufweist, die entweder kleiner oder größer ist als eine Querschnittfläche an der ersten und der zweiten Wärmeübertragungsplatte (1a, 1b).

2. Montage (10) nach Anspruch 1, wobei der Verbindungsabschnitt eingerichtet ist, um nachgiebiges Stützen der ersten und der zweiten Wärmeübertragungsplatte bereitzustellen, das es der ersten und der zweiten Wärmeübertragungsoberfläche erlaubt, zueinander und voneinander weg bewegbar zu sein.

3. Montage (10) nach Anspruch 1 oder 2, wobei die erste und die zweite Wärmeübertragungsplatte (1a, 1b) und mindestens ein Teil des Verbindungsabschnitts (2) als ein einziges einheitliches Teil (9) gebildet sind, wobei das einzige einheitliche Teil vorzugsweise eine Metallplatte ist, die gebildet ist, um die erste und die zweite Wärmeübertragungsplatte (1a, 1b) und mindestens einen Teil des Verbindungsabschnitts (2) zu definieren.

4. Montage (10) nach Anspruch 3, die weiter ein Kanalelement (6) umfasst, das mindestens teilweise die Wärmeübertragungsleitung (5) und mindestens einen Teil des Verbindungsabschnitts (2) definiert, wobei das Kanalelement an dem einzelnen einheitlichen Teil (9) gesichert sind.

5. Montage (10) nach Anspruch 4, die weiter Beabstandungselemente zwischen dem Kanalelement (6) und dem einzelnen einheitlichen Teil (9) in dem Verbindungsabschnitt (2) umfassen, um ein Maß der Wärmeübertragungsleitung (5) zu definieren.

6. Montage (10) nach Anspruch 5, wobei:
das Kanalelement (6) und das einzige einheitliche Teil (9) jeweils einen Umfang aufweisen, wobei die Umfänge des Kanalelements und des einzelnen einheitlichen Teils abdichtend aneinander gefügt sind; und/oder
das Kanalelement aus einem Plattenmaterial gebildet ist, das gebogen ist, um eine konvexe Sektion zu definieren, die einen Teil der Wärmeübertragungsleitung definiert.

7. Montage (10) nach einem der vorstehenden Ansprüche, wobei
der Einlassanschluss (3) an die erste Wärmeübertragungsplatte (1a) angrenzend liegt, und der Auslassanschluss (4) an die zweite Wärmeübertragungsplatte (1b) angrenzend liegt; und/oder
die Montage weiter ein Kanalelement (6) umfasst, das mindestens einen Abschnitt der Wärmeübertragungsleitung (5) und den Einlass- und den Auslassanschluss definiert, wobei sich das Kanalelement von der ersten Wärmeübertragungsplatte zu der zweiten Wärmeübertragungsplatte entlang des Verbindungsabschnitts (2) erstreckt, wobei das Kanalelement optional abdichtend in den Verbindungsabschnitt derart eingreift, dass das Kanalelement und der Verbindungsabschnitt gemeinsam mindestens einen Abschnitt der Wärmeübertragungsleitung definieren.

8. Montage (10) nach einem der vorstehenden Ansprüche, wobei
die Wärmeübertragungsleitung (5) und der Einlass- und der Auslassanschluss (3, 4) derart eingerichtet sind, dass Wärmeübertragungsfluid von der ersten Wärmeübertragungsplatte (1a) zu der zweiten Wärmeübertragungsplatte (1b) und zurück zu der ersten Wärmeübertragungsplatte fließt, bevor es die Wärmeübertragungsleitung über den Auslassanschluss verlässt; und/oder
die erste und die zweite Wärmeübertragungsplatte jeweils eine Seite jeweils der ersten und der zweiten Wärmeübertragungsoberfläche entgegengesetzt aufweisen, die für Berührung mit dem Wärmeübertragungsfluid in der Wärmeübertragungsleitung exponiert sind.

9. Montage (10) nach einem der vorstehenden Ansprüche, die weiter mindestens eine Befestigung (8) umfasst, die die erste und die zweite Wärmeübertragungsplatte (1a, 1b) drückt, um sich zueinander zu bewegen, um ein Bauteil (20) zwischen der ersten und der zweiten Wärmeübertragungsplatte zu sichern, wobei die mindestens eine Befestigung optional integral mit der ersten Wärmeübertragungsplatte gebildet ist.

10. Montage (10) nach einem der vorstehenden Ansprüche, wobei der Verbindungsabschnitt (2) eine Biegung beinhaltet, die sich entlang eines Bogens von mindestens 90 Grad erstreckt.

11. Montage (10) nach einem der vorstehenden Ansprüche, wobei
die erste und die zweite Wärmeübertragungsoberfläche flach sind; und/oder
die Wärmeübertragungsoberflächen durch metallische Elemente definiert sind, und der Verbindungsabschnitt (2) und die Wärmeübertragungsleitung (5) mindestens zum Teil aus einem Polymerelement gebildet sind, wobei die metallischen Elemente vorzugsweise gemeinsam mit dem Polymerelement geformt oder daran geklebt sind; und/oder
die Wärmeübertragungsplatten (1a, 1b) jeweils aus einem metallischen Element gebildet sind, und die Wärmeübertragungsplatten mit einem Polymerelement geformt sind, das mindestens zum Teil den Verbindungsabschnitt, den Einlassanschluss (3), den Auslassanschluss (4) und/oder die Wärmeübertragungsleitung definiert.

12. Verfahren zum Bilden einer Montage (10) zum Übertragen von Wärme in Bezug auf ein Bauteil (20), das umfasst:
Bereitstellen einer ersten und einer zweiten Wärmeübertragungsplatte (1a, 1b), die jeweils eine erste und eine zweite Oberfläche aufweisen, die eingerichtet sind, um die erste und die zweite Bauteiloberfläche zu berühren und Wärme zu ihnen zu übertragen, wobei die erste und die zweite Wärmeübertragungsplatte durch einen Verbindungsabschnitt (2) verbunden sind, der sich zwischen der ersten und der zweiten Wärmeübertragungsplatte erstreckt;
Biegen des Verbindungsabschnitts (2) derart, dass die zweite Wärmeübertragungsoberfläche der ersten Wärmeübertragungsoberfläche gegenüberliegt und in einem Winkel von mindestens 30 Grad zu der ersten Wärmeübertragungsoberfläche eingerichtet ist, wobei der gebogene Verbindungsabschnitt nachgiebiges Stützen der ersten und der zweiten Wärmeübertragungsplatte bereitstellt, das es der ersten und der zweiten Wärmeübertragungsoberfläche erlaubt, zueinander und voneinander weg bewegbar zu sein; und
Bereitstellen einer Wärmeübertragungsleitung (5), die eingerichtet ist, um einen Fluss von Wärmeübertragungsfluid zu der ersten und der zweiten Wärmeübertragungsplatte zu leiten, wobei die Wärmeübertragungsleitung mindestens eine Passage beinhaltet, die sich von der ersten Wärmeübertragungsplatte zu dem Verbindungsabschnitt und von dem Verbindungsabschnitt zu der zweiten Wärmeübertragungsplatte erstreckt,
**dadurch gekennzeichnet, dass** die Wärmeübertragungsleitung eine Querschnittfläche in einem Teil des Verbindungsabschnitts aufweist, die entweder kleiner oder größer ist als eine Querschnittfläche an der ersten und der zweiten Wärmeübertragungsplatte.

13. Verfahren nach Anspruch 12, das weiter umfasst:
Bereitstellen von Einlass- und eines Auslassanschlüssen (3, 4), die jeweils eingerichtet sind, um Wärmeübertragungsfluid in die Wärmeübertragungsleitung (5) und aus der Wärmeübertragungsleitung heraus zu leiten.

14. Verfahren nach Anspruch 12 oder 13, wobei
der Schritt des Bereitstellens der Wärmeübertragungsleitung (5) das Sichern eines Kanalelement (6) an dem Verbindungsabschnitt (2) derart umfasst, dass das Kanalelement und der Verbindungsabschnitt gemeinsam mindestens zum Teil die Wärmeübertragungsleitung definieren, wobei Beabstandungselemente zwischen dem Kanalelement (6) und dem einzelnen einheitlichen Teil (9) in dem Verbindungsabschnitt (2) bereitgestellt sind, um ein Maß der Wärmeübertragungsleitung (5) zu definieren; und/oder
der Schritt des Sicherns des Kanalelements an dem Verbindungsabschnitt vor dem Schritt des Biegens des Verbindungsabschnitts ausgeführt wird, und der Schritt des Biegens des Verbindungsabschnitts das Biegen des Kanalelements beinhaltet; und/oder
der Schritt des Biegens des Verbindungsabschnitts das Biegen eines Teils des Verbindungsabschnitts beinhaltet, um eine Biegung zu bilden, die sich entlang von mindestens 90 Grad erstreckt.

15. Verfahren nach einem der Ansprüche 12 bis 14, wobei der Schritt des Bereitstellens der ersten und der zweiten Wärmeübertragungsplatte (1a, 1b) das Bereitstellen eines einzigen einheitlichen Teils beinhaltet, das die erste und die zweite Wärmeübertragungsplatte und den Verbindungsabschnitt (2) definiert, wobei das Kanalelement (6) optional einen konvexen Abschnitt aufweist, der mindestens zum Teil die Wärmeübertragungsleitung (5) und eine Umfangskante definiert, und der Schritt des Sicherns des Kanalelements an dem Verbindungsabschnitt das abdichtende Sichern der Umfangskante des Kanalelements an dem einzigen einheitlichen Teil derart beinhaltet, dass das Kanalelement und das einzige einheitliche Teil gemeinsam die Wärmeübertragungsleitung definieren.

## Revendications

1. Ensemble (10) pour transférer de la chaleur par rapport à un composant (20), comprenant :
une première plaque de transfert de chaleur (1a) présentant une première surface de transfert de chaleur agencée pour être en contact avec une première surface de composant et transférer de la chaleur par rapport à celle-ci ;
une seconde plaque de transfert de chaleur (1b) présentant une seconde surface de transfert de chaleur agencée pour être en contact avec une seconde surface de composant et transférer de la chaleur par rapport à celle-ci et agencée selon un angle de 270 degrés ou moins par rapport à la première surface de transfert de chaleur ;
une portion de liaison (2) s'étendant entre les première et seconde plaques de transfert de chaleur et reliant celles-ci l'une à l'autre, la portion de liaison incluant un coude qui s'étend le long d'un arc d'au moins 30 degrés ;
un conduit de transfert de chaleur (5) agencé pour conduire un écoulement de fluide de transfert de chaleur jusqu'aux première et seconde plaques de transfert de chaleur, le conduit de transfert de chaleur incluant au moins un passage qui s'étend depuis la première plaque de transfert de chaleur jusqu'à la portion de liaison et depuis la portion de liaison jusqu'à la seconde plaque de transfert ;
le conduit de transfert de chaleur présentant une section transversale dans une partie de la portion de liaison qui est différente d'une section transversale près des première et seconde plaques de transfert de chaleur ; et
des orifices d'entrée et sortie (3, 4) agencés pour conduire respectivement le fluide de transfert de chaleur dans le conduit de transfert de chaleur et hors du conduit de transfert de chaleur,
**caractérisé en ce que** le conduit de transfert de chaleur (5) présente une section transversale dans une partie de la portion de liaison (2) qui est plus petite ou plus grande qu'une section transversale au niveau des première et seconde plaques de transfert de chaleur (1a, 1b).

2. Ensemble (10) selon la revendication 1, dans lequel la portion de liaison est agencée pour fournir un support flexible des première et seconde plaques de transfert de chaleur qui permet aux première et seconde plaques de transfert de chaleur de se rapprocher ou de s'éloigner l'une de l'autre.

3. Ensemble (10) selon la revendication 1 ou 2, dans lequel les première et seconde plaques de transfert de chaleur (1a, 1b) et au moins une partie de la portion de liaison (2) sont formées en tant que partie unitaire unique (9), la partie unitaire unique étant de préférence une feuille de métal formée pour définir les première et seconde plaques de transfert de chaleur (1a, 1b) et au moins une partie de la portion de liaison (2).

4. Ensemble (10) selon la revendication 3, comprenant en outre un élément canal (6) qui définit au moins partiellement le conduit de transfert de chaleur (5) et au moins une partie de la portion de liaison (2), l'élément canal étant fixé à la partie unitaire unique (9).

5. Ensemble (10) selon la revendication 4, comprenant en outre des éléments d'écartement entre l'élément canal (6) et la partie unitaire unique (9) dans la portion de liaison (2) pour définir une dimension du conduit de transfert de chaleur (5).

6. Ensemble (10) selon la revendication 5, dans lequel :
l'élément canal (6) et la partie unitaire unique (9) présentent chacun une périphérie, dans lequel les périphéries de l'élément canal et de la partie unitaire unique sont jointes de manière étanche entre elles ; et/ou
l'élément canal est formé à partir d'un matériau en feuille qui est plié pour définir une section convexe qui définit une partie du conduit de transfert de chaleur.

7. Ensemble (10) selon l'une quelconque des revendications précédentes, dans lequel
l'orifice d'entrée (3) est situé de manière adjacente à la première plaque de transfert de chaleur (1a), et l'orifice de sotie (4) est situé de manière adjacente à la seconde plaque de transfert de chaleur (1b) ; et/ou
l'ensemble comprend en outre un élément canal (6) qui définit au moins une portion du conduit de transfert de chaleur (5) et des orifices d'entrée et de sortie, l'élément canal s'étendant depuis la première plaque de transfert de chaleur jusqu'à la seconde plaque de transfert de chaleur le long de la portion de liaison (2), l'élément de canal étant optionnellement en prise étanche avec la portion de liaison de telle sorte que l'élément canal et la portion de liaison définissent ensemble au moins une portion du conduit de transfert de chaleur.

8. Ensemble (10) selon l'une quelconque des revendications précédentes, dans lequel
le conduit de transfert de chaleur (5) et les orifices d'entrée et de sortie (3, 4) sont agencés de telle sorte qu'un fluide de transfert de chaleur s'écoule depuis la première plaque de transfert de chaleur (1a) jusqu'à la seconde plaque de transfert de chaleur (1b) et de retour jusqu'à la première plaque de transfert de chaleur avant de sortir du conduit de transfert de chaleur via l'orifice de sortie ; et/ou
les première et seconde plaques de transfert de chaleur présentent chacune un côté respectivement opposé des première et seconde surfaces de transfert de chaleur qui sont exposées pour un contact avec le fluide de transfert de chaleur dans le conduit de transfert de chaleur.

9. Ensemble (10) selon l'une quelconque des revendications précédentes, comprenant en outre au moins un élément de fixation (8) qui pousse les première et seconde plaques de transfert de chaleur (1a, 1b) à se déplacer l'une vers l'autre pour fixer un composant (20) entre les première et seconde plaques de transfert de chaleur, dans lequel l'au moins un élément de fixation est optionnellement formé d'un seul tenant avec la première plaque de transfert de chaleur.

10. Ensemble (10) selon l'une quelconque des revendications précédentes, dans lequel la portion de liaison (2) inclut un coude qui s'étend le long d'un arc d'au moins 90 degrés.

11. Ensemble (10) selon l'une quelconque des revendications précédentes, dans lequel
les première et seconde surfaces de transfert de chaleur sont planaires ; et/ou
les surfaces de transfert de chaleur sont définies par des éléments métalliques, et la portion de liaison (2) et le conduit de transfert de chaleur (5) sont formés au moins en partie par un élément polymère, dans lequel les éléments métalliques sont de préférence co-moulés avec l'élément polymère ou liés à celui-ci ; et/ou
les plaques de transfert de chaleur (1a, 1b) sont chacune formées d'un élément métallique et les plaques de transfert de chaleur sont moulées avec un élément polymère qui définit au moins en partie la portion de liaison, l'orifice d'entrée (3), l'orifice de sortie (4) et/ou le conduit de transfert de chaleur.

12. Procédé pour former un ensemble (10) pour transférer de la chaleur par rapport à un composant (20), comprenant :
la fourniture des première et seconde plaques de transfert de chaleur (1a, 1b) présentant respectivement des première et seconde surfaces agencées pour être en contact avec des première et seconde surfaces de composant et transférer de la chaleur par rapport à celles-ci, les première et seconde plaques de transfert de chaleur étant reliées par une portion de liaison (2) s'étendant entre les première et seconde plaques de transfert de chaleur ;
la courbure de la portion de liaison (2) de telle sorte que la seconde surface de transfert de chaleur fait face à la première surface de transfert de chaleur et est agencée selon un angle d'au moins 30 degrés par rapport à la première surface de transfert de chaleur, la portion de liaison courbée fournissant un support flexible des première et seconde plaques de transfert de chaleur qui permet aux première et seconde surfaces de transfert de chaleur de se rapprocher ou de s'éloigner l'une de l'autre ; et
la fourniture d'un conduit de transfert de chaleur (5) agencé pour conduire un écoulement de fluide de transfert de chaleur jusqu'aux première et seconde plaques de transfert de chaleur, le conduit de transfert de chaleur incluant au moins un passage qui s'étend depuis la première plaque de transfert de chaleur jusqu'à la portion de liaison et depuis la portion de liaison jusqu'à la seconde plaque de transfert de chaleur, **caractérisé en ce que** le conduit de transfert de chaleur présente une section transversale dans une partie de la portion de liaison qui est plus petite ou plus grande qu'une section transversale au niveau des première et seconde plaques de transfert de chaleur.

13. Procédé selon la revendication 12, comprenant en outre :
la fourniture d'orifices d'entrée et de sortie (3, 4) agencés pour conduire respectivement un fluide de transfert de chaleur dans le conduit de transfert de chaleur (5) et hors du conduit de transfert de chaleur.

14. Procédé selon la revendication 12 ou 13, dans lequel
l'étape de fourniture du conduit de transfert de chaleur (5) comprend la fixation d'un élément canal (6) sur la portion de liaison (2) de telle sorte que l'élément canal et la portion de liaison définissent ensemble au moins en partie le conduit de transfert de chaleur, dans lequel des éléments d'écartement sont situés entre l'élément canal (6) et la partie unitaire unique (9) dans la portion de liaison (2) pour définir une dimension du conduit de transfert de chaleur (5) ; et/ou
l'étape de fixation de l'élément canal à la portion de liaison est effectuée avant l'étape de courbure de la portion de liaison, et l'étape de courbure de la portion de liaison inclut la courbure de l'élément canal ; et/ou
l'étape de courbure de la portion de liaison inclut la courbure d'une partie de la portion de liaison pour former un coude qui s'étend le long d'au moins 90 degrés.

15. Procédé selon l'une quelconque des revendications 12 à 14, dans lequel l'étape de fourniture des première et seconde plaques de transfert de chaleur (1a, 1b) inclut la fourniture d'une partie unitaire unique qui définit les première et seconde plaques de transfert de chaleur et la portion de liaison (2), dans lequel l'élément canal (6) présente optionnellement une portion convexe qui définit au moins en partie le conduit de transfert de chaleur (5) et un bord périphérique et l'étape de fixation de l'élément canal à la portion de liaison inclut la fixation étanche du bord périphérique de l'élément canal à la partie unitaire unique de telle sorte que l'élément canal et la partie unitaire unique définissent ensemble le conduit de transfert de chaleur.
